# EUROPÄISCHE PATENTSCHRIFT

(11) **EP 4 010 913 B1**
(45) Veröffentlichungstag und Bekanntmachung des Hinweises auf die Patenterteilung: **05.11.2025**
(21) Anmeldenummer: 20754706.8
(22) Anmeldetag: 07.08.2020
(51) Int. Cl.: H01F 41/30, B29C 64/112

(54) **VERFAHREN ZUM HERSTELLEN EINES GEDRUCKTEN MAGNETISCHEN FUNKTIONSELEMENTS UND GEDRUCKTES MAGNETISCHES FUNKTIONSELEMENT**
METHOD FOR PRODUCING A PRINTED MAGNETIC FUNCTIONAL ELEMENT, AND PRINTED MAGNETIC FUNCTIONAL ELEMENT
PROCÉDÉ DE FABRICATION D'UN ÉLÉMENT FONCTIONNEL MAGNÉTIQUE IMPRIMÉ, ET ÉLÉMENT FONCTIONNEL MAGNÉTIQUE IMPRIMÉ

(30) Priorität: 09.08.2019 DE 102019211970
(43) Veröffentlichungstag der Anmeldung: 15.06.2022
(73) Patentinhaber: Fraunhofer-Gesellschaft zur Förderung der angewandten Forschung e.V., 80686 München (DE); Helmholtz-Zentrum Dresden - Rossendorf e.V., 01328 Dresden (DE)
(72) Erfinder: VINNICHENKO, Mykola, 01277 Dresden (DE); TROFIMENKO, Nikolai, 01277 Dresden (DE); SAUCHUK, Viktar, 01277 Dresden (DE); MOSCH, Sindy, 01277 Dresden (DE); FRITSCH, Marco, 01277 Dresden (DE); KUSNEZOFF, Mihails, 01277 Dresden (DE); MÖNCH, Jens-Ingolf, 01328 Dresden (DE); MAKAROV, Denys, 01328 Dresden (DE); CANON BERMÚDEZ, Gilbert Santiago, 01328 Dresden (DE)
(74) Vertreter: Pfenning, Meinig & Partner mbB
(86) Internationale Anmeldenummer: PCT/EP2020/072231
(87) Internationale Veröffentlichungsnummer: WO 2021/028334

(56) Entgegenhaltungen:
- EP-A2- 2 003 940
- WO-A1-2016/094827
- CN-B- 105 036 057
- US-A1- 2018 286 940
- MAKAROV DENYS ET AL: "Shapeable magnetoelectronics", APPLIED PHYSICS REVIEWS, AMERICAN INSTITUTE OF PHYSICS, 2 HUNTINGTON QUADRANGLE, MELVILLE, NY 11747, vol. 3, no. 1, 12 January 2016 (2016-01-12), XP012211165, DOI: 10.1063/1.4938497

## Beschreibung

Die vorliegende Erfindung betrifft ein Verfahren zum Herstellen eines gedruckten magnetischen Funktionselements.

Magnetowiderstandssensoren durch nasschemische Verfahren herzustellen ist ein attraktiver Ansatz, der Kostenvorteile gegenüber vakuumbasierten Dünnschichttechnologien verspricht, eine mechanische Flexibilität bei Druck auf Foliensubstrate bietet und eine Integration in existierende bzw. neuartige Messsysteme begünstigt. Nachteilig an derartigen Verfahren ist jedoch, dass zum Drucken verwendete Werkstoffe bzw. applizierte Druckschichten oftmals umständlich und langwierig im Ofen getrocknet und gegebenenfalls gesintert werden müssen, bis die gedruckte Struktur funktionsfähig ist. Dieser klassische Ansatz, d. h. eine Kombination von Bedruckung mit Ofenbehandlung, funktioniert nicht mit den meisten magnetoresistiven (MR) Werkstoffen, weswegen es bisher nur einzelne Beispiele gedruckter Magnetfeldsensoren gibt.

Beispielsweise offenbart die Druckschrift US 2012/0326714 A1 ein Verfahren zum Herstellen derartiger Sensoren, bei dem der Riesenmagnetowiderstandseffekt (giant magnetoresistance, GMR) ausgenutzt wird. Hierbei wird das Werkstoffsystem mittels physikalischer Gasphasenabscheidung auf ein Substrat aufgebracht, dann davon entfernt, kontrolliert gemahlen und zu einer druckfähigen Paste verarbeitet. Nach dem Drucken dieser Paste und Trocknen derselben wird ein funktionsfähiger GMR-Sensor erhalten. Dabei ist, neben der komplizierten Verarbeitung der Paste selbst, die mangelnde Skalierbarkeit aufgrund der Kosten zum Herstellen eines gemahlenen Pulvers nachteilig.

Die CN 105 036 057 B offenbart ein Verfahren zur Herstellung von strukturierten magnetischen Mikro-Nano-Strukturen und zum Einstellen gewünschter Oberflächeneigenschaften. Das Verfahren umfasst das Aufbringen und Ausrichten eines in einer Flüssigkeit gelöstem Magnetpulvers, das per Magnetfeld ausgerichtet und mittels eines Wärmeeintrags verschmolzen wird.

Die US 2018/286940 A1 lehrt ein Verfahren zur Herstellung einer Vorrichtung mit einer integrierten magnetischen Komponente unter Verwendung von 3-dimensionalem (3-D) Drucken. Das Verfahren umfasst die Bereitstellung eines Substrats mit einer dielektrischen Basisschicht, wobei die dielektrische Basisschicht als Basis für die integrierte magnetische Komponente dient. Eine erste Metallschicht wird auf dem Substrat durch Aufsprühen von Metallpulver auf das Substrat und selektives Laserschmelzen des Metallpulvers gebildet. Ein Magnetkern wird auf dem Substrat durch Aufsprühen von Magnetpulver auf das Substrat und selektivem Lasersintern des Magnetpulvers gebildet. Eine zweite Metallschicht wird auf dem Substrat durch Aufsprühen von Metallpulver auf das Substrat und selektives Laserschmelzen des Metallpulvers gebildet. Eine strukturierte dielektrische Schicht trennt die erste und zweite Metallschicht und den Magnetkern.Die WO 2016/094827 A1 offenbart eine Lösung zum geregelten Drucken eines dreidimensionalen Objekts durch sensorisches Erfassen eines Materialbetts.

Der vorliegenden Erfindung liegt daher die Aufgabe zugrunde, ein Verfahren vorzuschlagen, das die genannten Nachteile vermeidet, mit dem also ein magnetisches Funktionselement einfach und effizient herstellbar ist.

Diese Aufgabe wird erfindungsgemäß gelöst durch ein Verfahren nach dem unabhängigen Anspruch 1.

Vorteilhafte Ausgestaltungen und Weiterbildungen sind in den abhängigen Ansprüchen beschrieben.

Bei einem Verfahren zum Herstellen eines gedruckten magnetischen Elements wird ein Substrat auf einer Oberfläche mit mindestens einem Kontakt aus einem elektrisch leitfähigen Werkstoff versehen. Es wird auf den oder an den mindestens einen Kontakt und diesen unmittelbar berührend eine unter, über und bzw. oder neben dem Kontakt angeordnete Struktur aufgedruckt, die als Paste, als Gel, als Dispersion oder als Suspension vorliegt und einen Werkstoff umfasst, der einen magnetoresistiven Effekt aufweist. Anschließend wird der Kontakt und bzw. oder die Struktur durch eine Bestrahlung mit elektromagnetischer Strahlung über einen Zeitraum im Millisekundenbereich funktionalisiert und zumindest durch ein Ausbilden einer mechanischen Anbindung zwischen einzelnen Partikeln des elektrisch leitfähigen Werkstoffs und bzw. oder des einen magnetoresistiven Effekt aufweisenden Werkstoffs elektrisch leitfähig und magnetfeldempfindlich, d. h. dass die gesamte Struktur oder zumindest einzelne Teile davon einen magnetoresistiven Effekt aufweisen. Es kann auch vorgesehen sein, dass die Funktionalisierung der Struktur in zwei Schritten durchgeführt wird: Zuerst ein Trocknen und nachfolgend die Bestrahlung mit elektromagnetischer Strahlung über einen Zeitraum im Millisekundenbereich, was Sintern, Pyrolyse, Zersetzung organischer Komponenten und bzw. oder Entfernung von Oberflächenoxiden verursacht. Der einen magnetoresistiven Effekt aufweisende Werkstoff ist ausgewählt aus Bismut, Indium, Antimon oder einer Legierung der genannten Elemente oder enthält Bismut, Indium, Antimon oder eine Legierung der genannten Elemente. Das Aufbringen der Struktur und des Kontakts kann hierbei sowohl derart erfolgen, dass zuerst der Kontakt auf der Oberfläche des Substrats aufgebracht wird und nachfolgend die Struktur aufgebracht wird als auch derart, dass zuerst die Struktur erzeugt wird und nachfolgend der Kontakt. In letztgenanntem Fall ist somit der mindestens eine Kontakt gegebenenfalls nur in mittelbar berührendem Kontakt mit der Oberfläche des Substrats und die Struktur ist in unmittelbar berührendem, d. h. direktem Kontakt mit der Oberfläche. Unter der mechanischen Anbindung soll ein Ausbilden eines dauerhaften, direkten Kontakts zwischen den Partikeln verstanden werden, beispielsweise durch eine Sinterbrücke.

Durch ein Funktionalisieren mittels der Bestrahlung mit elektromagnetischer Strahlung, die das Auftreten der elektrischen Leitfähigkeit und des magnetoresistiven Effekts ermöglicht, kann die Struktur deutlich schneller als mit konventionellen Methoden mit den gewünschten Eigenschaften versehen werden. Das Drucken der Struktur ermöglicht es außerdem, schnell und kostengünstig die gewünschte Anordnung herzustellen. Zudem wird eine Adhäsion mit dem Substrat, z. B. durch lokale Teilaufschmelzung einer Oberfläche des Substrats, verbessert, ohne die magnetischen und elektrischen Eigenschaften in Mitleidenschaft zu ziehen. Unter einem elektrisch leitfähigen Werkstoff soll hierbei ein Werkstoff verstanden werden, dessen elektrische Leitfähigkeit mindestens 10³ S/m bei Raumtemperatur beträgt. Der magnetoresistive Effekt (MR-Effekt) soll im Rahmen dieser Schrift einen Effekt beschreiben, bei dem sich ein elektrischer Widerstand des jeweiligen Werkstoffs bei Anlegen eines Magnetfelds bei Gleichstrom und bzw. oder Wechselstrom (Magnetoimpedanz) ändert. Insbesondere soll hierunter der gewöhnliche Magnetowiderstandseffekt (ordinary magnetoresistive effect, OMR, ohne ferromagnetisches Ordnen) verstanden werden.

Alternativ oder zusätzlich kann die Struktur und bzw. oder der Kontakt auch in einem Ofen getrocknet werden und nachfolgend mit der elektromagnetischen Strahlung bestrahlt werden, so dass der entsprechende Werkstoff direkt nach der Trocknung elektrisch leitfähig wird und die nachfolgende Bestrahlung im Millisekundenbereich eine weitere Verbesserung der elektrischen Leitfähigkeit bzw. der magnetoresistiven Eigenschaften ermöglicht. Unter einem Gel soll hierbei insbesondere ein disperses, aus mindestens zwei Komponenten bestehendes System verstanden werden, wobei eine der Komponenten in flüssiger Form und die andere Komponente bei Raumtemperatur, d. h. 20 °C, in fester Form vorliegt und ein schwammartiges, dreidimensionales Netzwerk bildet. Unter einer Paste soll insbesondere eine nicht mehr fließfähige Suspension verstanden werden, die einen hohen Gehalt an Festkörpern, typischerweise mehr als 10 Gewichtsprozent, aufweist. Unter einer Struktur soll im Rahmen dieser Schrift insbesondere eine Schicht mit einer definierten äußeren Kontur verstanden werden, die typischerweise in einem einzigen Verfahrensschritt aufgebracht ist und vorzugsweise einlagig, d. h. nur aus einer einzigen Lage bestehend, ausgebildet ist.

Der Zeitraum im Millisekundenbereich, in dem die Bestrahlung erfolgt, kann zwischen 0,1 ms und 100 ms betragen. Vorzugsweise beträgt dieser Zeitraum zwischen 0,5 ms und 2 ms, besonders vorzugsweise genau 2 ms. Hiermit wird über einen kurzen Zeitraum ausreichend Energie aufgebracht, was gleichzeitig eine Taktzahl des Herstellungsprozesses ausreichend hoch ausfallen lässt, so dass dieses Verfahren auch für eine Rolle-zu-Rolle-Produktion geeignet ist. Die Struktur kann eine Dicke von bis zu 100 µm aufweisen, wird aber typischerweise mit einer Dicke von bis zu 10 µm aufgebracht. Ebenso kann auch der mindestens eine Kontakt mit einer Dicke bis zu 10 µm aufgebracht werden.

Typischerweise wird die Bestrahlung mit elektromagnetischer Strahlung mit einer Laserstrahlung, vorzugsweise Diodenlaserstrahlung, und bzw. oder einer Bestrahlung mit einer Blitzlampe durchgeführt, um schnell und kostengünstig die gewünschten Effekte hervorzurufen. Im Fall von Laserstrahlung kann beispielsweise ein Nahinfrarotspektralbereich verwendet werden (d. h. eine Laserstrahlungsquelle, die Laserstrahlung mit einer Wellenlänge aus dem Wellenlängenspektrum zwischen 700 nm und 2000 nm emittiert). Eine Strahlungsintensität kann im Bereich einiger kW/cm² liegen, typischerweise im Bereich von nicht mehr als 50 kW/cm². Im Fall eine Blitzlampenbearbeitung kann ein Spektralbereich von naher Ultraviolettstrahlung bis Nahinfrarot verwendet werden, d. h. ein Wellenlängenbereich von 300 nm bis 2000 nm. Die verwendete Leistung entspricht der für eine Laserbehandlung verwendeten Strahlungsintensität von typischerweise 1-30 kW/cm².

Der mindestens eine Kontakt aus einem elektrisch leitfähigen Werkstoff wird durch mindestens einen Druckvorgang, Gasphasenabscheidung oder eine Laminierung des Kontakts aufgebracht. Bevorzugt ist jedoch der Druckvorgang. Dabei können möglichst gleichartige Verfahrensschritte zum Erhöhen einer Verfahrenseffizienz durchgeführt werden. Der mindestens eine Kontakt kann hierbei als elektrische Leiterbahn ausgestaltet werden.

Zum Drucken der Struktur wird typischerweise ein Gel, eine Paste, eine Dispersion oder eine Suspension aus dem Werkstoff, der den gewöhnlichen Magnetowiderstandseffekt aufweist, enthaltenden Pulver, einem ein Polymer aufweisendem Dispergiermittel und bzw. oder einem Binder hergestellt. Die mittlere Partikelgröße des Werkstoff enthaltenden Pulvers liegt vorzugsweise zwischen 10 nm und 100 µm, besonders vorzugsweise zwischen 100 nm und 10 µm.

Hinsichtlich geeigneter Tenside zur Stabilisierung der Partikel können entweder wässrige oder nicht wässrige Formulierungen verwendet werden. Für wässrige Druckformulierungen werden bevorzugt ionisch, elektrosterisch oder sterisch wirkende Tenside eingesetzt. Dies sind insbesondere saure oder basisch funktionalisierte Polymere, vorzugsweise solche mit polaren funktionellen Gruppen. Beispielsweise kommen hier Polymere aus der Gruppe der funktionalisierten Polyamine, Polyurethane, Polymethacrylate allein oder deren Kombinationen untereinander oder in Kombination mit einem Adipat, Adipinsäure und Polycarbonsäure in Betracht. Auch organischen Säuren, wie Sulfonsäuren und Sulfonsäureester, aber auch Polyacrylsäure, sind geeignet. Es können auch andere bekannte anionische Tenside, oder eine Kombination verschiedener solcher Tenside, angewendet werden. Beispiele elektrosterisch wirkender Tenside sind NaC₁₊ₙH₃₊₂ₙSO₄, NaC₁₊ₙH₃₊₂ₙSO₃ und NaC₁₊ₙH₃₊₂ₙSO₃. Beispiele für Tenside auf Basis mehrwertigen aliphatischen Säuren sowie sterisch wirkenden Tensiden wären Sulfobernsteinsäure, Zitronensäure, Trinatriumcitrat, Sebacinsäure, Dodekandisäure und Polyvinylpyrolidon. Insbesondere, aber nicht ausschließlich, sind auch Seifen auf Basis Alkali- oder Erdalkalisalze von langkettigen Karbonsäuren, z.B. Natriumstearat, geeignet. Für nicht wässrige Formulierungen können insbesondere hochmolekulare Polymere mit pigmentaffinen Gruppen, beispielsweise Alkylolammoniumsalze eines Copolymeren mit sauren Gruppen bzw. auch polare saurer Ester von höhermolekularen Alkoholen eingesetzt werden.

Ein Bindemittel bzw. der Binder soll definiert sein als eine Kombination eines der Lösungsmittel und eines bestimmten Polymers. In dieser Kombination ist das Lösungsmittel beispielhaft Terpineol, Diethylenglykol, Toluol oder Wasser während das Bindemittel typischerweise Polyvinylbutyral (PVB), Polyvinylalkohol (PVA), Polypropylen-Carbonat oder eine Cellulose ist.

Unter Drucken soll hierbei insbesondere ein Pressen, Stempeln, Aufmalen, Ausstreichen, Aufsprühen, Siebdrucken, Lithografie, automatisches Pipettieren, insbesondere mittels eines Nanoplotters, Offset- Drucken, Gravur-Drucken, Flexo-Drucken, Ink-Jet-Drucken oder Aerosol-Drucken verstanden werden. Vorzugsweise wird Siebdrucken verwendet. Allgemein kann unter dem Drucken der Struktur das Aufbringen der Paste als Gel, als Dispersion oder als Suspension mit einer definierten äußeren Kontur auf oder an den mindestens einen Kontakt verstanden werden, wobei die Konturierung, d. h. die Formgebung, der Struktur durch das Drucken bzw. beim Drucken erfolgt.

Falls zum Drucken der Struktur eine binderfreie Suspension oder ein binderfreies Pulver verwendet wird, die auf das Substrat aufgebracht wird, kann vorgesehen sein, nach dem Aufbringen durch eine Druckbeaufschlagung und bzw. oder Anwenden mechanischer Reibung in Kombination mit der Bestrahlung mit elektromagnetischer Strahlung über einen Zeitraum im Millisekundenbereich die Suspension bzw. das Pulver zu funktionalisieren, um einen magnetoresistiven Effekt zu erzielen.

Ein gedrucktes magnetisches Funktionselement weist ein Substrat mit mindestens einem auf einer Oberfläche des Substrats aufgebrachten Kontakt aus einem elektrisch leitfähigen Werkstoff auf. Auf dem mindestens einen Kontakt und diesen unmittelbar berührend ist eine Struktur aus einem magnetoresistiven Effekt aufweisenden Werkstoff aufgedruckt.

Der einen magnetoresistiven Effekt aufweisende Werkstoff ist ausgewählt aus Bismut, Indium, Antimon oder enthält eine Legierung der genannten Elemente oder Bismut, Indium, Antimon ober oder eine Legierung der genannten Elemente zumindest. Prinzipiell kann dieser Werkstoff auch ein keine ferromagnetische Ordnung aufweisender Werkstoff sein. Insbesondere Bismut ist aufgrund seines vergleichsweise großen magnetoresistiven Effekts ein geeigneter Werkstoff.

Ein Werkstoff, aus dem das Substrat ausgebildet ist, kann ein Glas, ein Halbleiter, vorzugsweise Silizium, eine Keramik, Papier, ein Textil, ein Gummi und bzw. oder ein Polymer, vorzugsweise Polyethylenterephthalat, Polyethylennaphthalat, Polyimid oder Polyetheretherketon oder ein Kompositwerkstoff, vorzugsweise das für Leiterplatten verwendete FR4 (also der in der Spezifikation NEMA LI1 festgelegte Werkstoff) sein oder zumindest aufweisen. Vorzugsweise ist das Substrat flexibel ausgestaltet, weist also vorzugsweise ein Elastizitätsmodul von maximal 10 GPa, vorzugsweise maximal 5 GPa, besonders vorzugsweise maximal 1 GPa bei einer Temperatur von 20 °C auf. Das Substrat kann auf seiner Oberfläche eine oder mehrere Hilfsschichten aufweisen, beispielsweise eine Glättungsschicht und bzw. oder eine Adhäsionszwischenschicht, so dass der Kontakt oder die Struktur das Substrat nicht unmittelbar berühren.

Um eine ausreichend hohe elektrische Leitfähigkeit sicherzustellen, kann der mindestens eine Kontakt aus einem elektrisch leitfähigen Werkstoff, vorzugsweise aus Silber, Gold, Platin, Kupfer, Aluminium oder einer Legierung der genannten Elemente ausgebildet sein oder diese zumindest aufweisen. Es kann aber auch vorgesehen sein, dass der mindestens eine Kontakt aus Bismut ausgebildet ist oder Bismut zumindest aufweist.

Das Substrat, der mindestens eine Kontakt und die aufgedruckte Struktur können zum Schutz vor mechanischer, chemischer oder thermischer Beschädigung, insbesondere vor Oxidation und Feuchtigkeit, mit einer organischen oder nichtorganischen Schutzschicht, wie zum Beispiel einem Photolack, eines Polymers, einer Keramik oder einer Glaskeramik, überzogen oder eingekapselt sein. Die Schutzschicht auf Polymerbasis kann hierbei Photolack, vorzugsweise SU-8, Polymethylmethacrylat (PMMA), oder Polyimid (PI) aufweisen oder enthalten.

Das beschriebene magnetische Funktionselement ist typischerweise mit dem beschriebenen Verfahren hergestellt, d. h. das beschriebene Verfahren ist zum Herstellen des beschriebenen magnetischen Funktionselements geeignet. Das Verfahren ist typischerweise zum Drucken, Streichen, Sprühen und nachfolgenden Trocknen, wie zuvor beschrieben, geeignet.

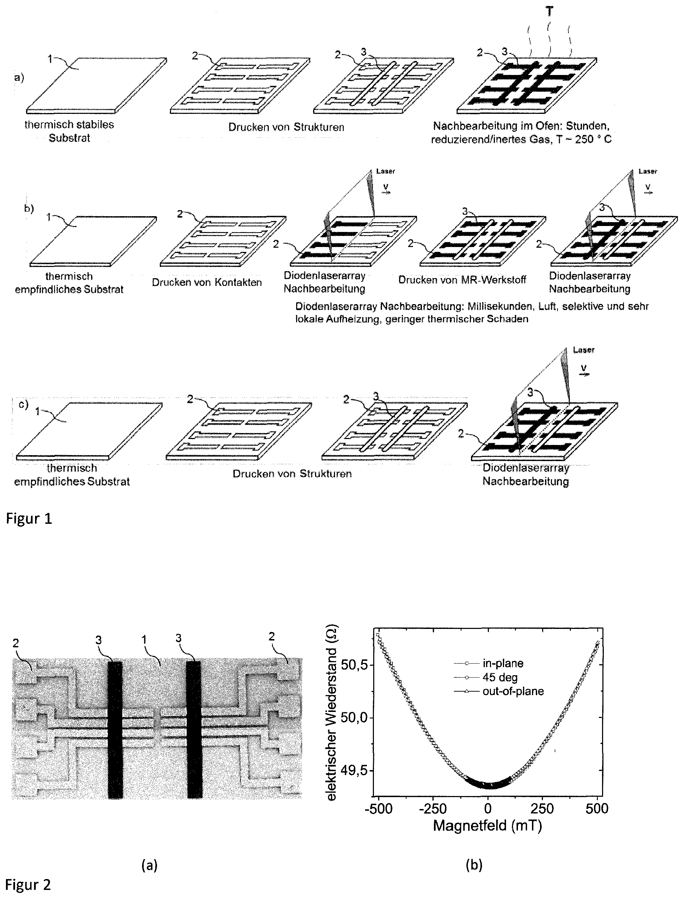

Ausführungsbeispiele der Erfindung sind in den Zeichnungen dargestellt und werden nachfolgend anhand der Figuren 1 und 2 erläutert.

Es zeigen:
- Fig. 1: einen schematischen Ablauf eines Herstellungsprozesses eines gedruckten magnetischen Funktionselement und
- Fig. 2: eine Draufsicht und ein Messwertediagramm des hergestellten gedruckten magnetischen Funktionselements.

Figur 1 zeigt in einer schematischen Ansicht ein Verfahren zum Herstellen gedruckter magnetischer Funktionselement. In Figur 1a), der oberen Abbildung, wird bei einem aus dem Stand der Technik bekannten Verfahren ein thermisch stabiles Substrat 1 durch Aufdrucken oder physikalische bzw. chemische Gasphasenabscheidung (physical vapor deposition, PVD, oder chemical vapor deposition, CVD) mit einer Kontaktstruktur 2 aus einem Metall versehen, die sich über eine Oberfläche des Substrats 1 erstreckt. Nachfolgend wird eine Struktur 3 aus einem einen magnetoresistiven Effekt aufweisenden Werkstoff aufgebracht und alles über Stunden, beispielsweise über drei Stunden, bei einer Temperatur von rund 250 °C in einer Inertgasatmosphäre oder im Vakuum wärmebehandelt.

Bei dem in Figur 1b), der mittleren Abbildung, dargestellten Ausführungsbeispiel eines erfindungsgemäßen Verfahrens kann auch ein thermisch weniger stabiles Substrat 1 verwendet werden. Auf die Oberfläche dieses Substrats 1 wird ebenfalls eine Kontaktstruktur 2 aus einem Metall, beispielsweise Silber, aufgebracht. Die Kontaktstruktur 2 wird durch ein Diodenlaserarray über 0,5 ms in einer Luftatmosphäre bestrahlt, wodurch der Werkstoff der Kontaktstruktur 2 getrocknet bzw. gesintert und elektrisch leitfähig wird. Anschließend wird die Struktur 3 aus Bismut als Dispersion aufgedruckt, die die Kontaktstruktur 2 berührt, mit dieser also in direktem, d. h. unmittelbar berührendem Kontakt steht. Diese Struktur 3 wird ebenfalls durch das Diodenlaserarray über 2 ms in einer Luftatmosphäre behandelt, wodurch das Bismut funktionalisiert und elektrisch leitfähig wird.

Bei dem in Figur 1b) gezeigten Ausführungsbeispiel wird somit nasschemisch eine bismutbasierte Struktur (d. h. Bismut oder eine Bismutlegierung) mit der Fähigkeit, magnetische Felder zu detektieren, hergestellt, indem zunächst eine Dispersion, Paste, Tinte oder wässrige Masse mit einem elektrisch leitfähigen oder halbleitenden Pulver hergestellt wird. Einzelne Werkstoffe sind hierbei wie beschrieben Bismut oder Bismutlegierungen.

Die mittlere Partikelgröße liegt hierbei zwischen 10 nm und 100 µm, wobei der Dispersion oder ähnlichem ein auf einem Polymer basierendes Dispergiermittel sowie ein Binder beigefügt werden.

Bei dem in Figur 1c), der unteren Abbildung, dargestellten Ausführungsbeispiel wird auch das thermisch empfindliche Substrat verwendet. Auf die Oberfläche dieses Substrats 1 wird die Kontaktstruktur 2 aus einem Metall, beispielsweise Silber, aufgebracht. Als nächster Schritt wird die Struktur 3 aus Bismut als Dispersion aufgedruckt, die die Kontaktstruktur 2 berührt, mit dieser also in direktem, d. h. unmittelbar berührendem Kontakt steht. Die gedruckten Strukturen werden dann zusammen durch das Diodenlaserarray über 1 ms in einer Luftatmosphäre behandelt, wodurch die beiden Komponenten funktionalisiert, d. h. getrocknet bzw. gesintert, werden.

Durch Tintenstrahldrucken (inkjet printing), Siebdruck, Schablonendruck oder Dispenserdruck der genannten Dispersion auf das steife oder flexible Substrat 1, das aus Glas, einem Siliziumwafer, einer Keramik, einem Metall, einem flexiblen Polymer, Papier, einem Textil oder einem Gummi ausgebildet sein kann, wird das Bismut als Struktur 3 abgeschieden bzw. aufgebracht. Als Struktur aufgebracht soll hierbei insbesondere bedeuten, dass die Dispersion bereits strukturiert, d. h. mit einer definierten äußeren Kontur, auf das Substrat aufgebracht wird, so dass keine zusätzlichen formgebenden Schichten auf dem Substrat ausgebildet werden oder nachfolgende formgebende Verfahrensschritte erfolgen. In gleicher Weise kann auch die Kontaktstruktur 2 aufgedruckt werden, es kann aber in weiteren Ausführungsbeispielen hierfür ein anderes Verfahren verwendet werden.

Beispielsweise kann ein konventioneller Prozess der physikalischen Gasphasenabscheidung oder chemischen Gasphasenabscheidung zum Aufbringen der Kontaktstruktur 2 aus zum Beispiel Gold, Platin, Silber, Aluminium oder Kupfer oder einer Legierung davon verwendet werden. Die Kontaktstruktur 2 kann hierbei unter, über oder neben der Struktur 3 angeordnet sein und ist typischerweise in Zwei-Punkt- oder Vier-Punkt-Messkonfiguration gestaltet.

Bismut als Sensorwerkstoff ist vorteilhaft, da es einen großen magnetoresistiven Effekt in Einkristallen zeigt sowie in 1 µm bis 20 µm dicken einkristallinen Filmen zeigt: Bei Raumtemperatur und Magnetfeldern bis zu 5 T bis zu 230 Prozent. Zudem ist Bismutpulver einfach erhältlich und produzierbar. Da Bismutschichten aber keine elektrische Leitfähigkeit direkt nach dem Drucken und Trocknen ohne thermische Nachbearbeitung zeigen, muss in der Regel ein Heizprozess in einem Ofen durchgeführt werden. Nach der vorliegenden Erfindung können die elektrische Leitfähigkeit und der magnetoresistive Effekt schneller und zuverlässiger durch eine Bestrahlung mit elektromagnetischer Strahlung realisiert werden, was auch die Notwendigkeit eines sich an die thermische Behandlung anschließenden Nachbearbeitungsschritts wie z. B. Polieren, um organische Zersetzungsprodukte zu entfernen, entfallen lässt. Durch die Bestrahlung im Millisekundenbereich zeigt ein derartig hergestellter Sensor eine isotrope Sensitivität und einen magnetoresistiven Effekt im Bereich von ca. 4-6 Prozent bei einer magnetischen Feldstärke von 500 mT, die durch Optimierung voraussichtlich auf mehr als 8 Prozent gesteigert werden kann.

Eine Funktionalisierung der Struktur 3, die das Auftreten von elektrischer Leitfähigkeit und magnetoresistiver Funktionalität ermöglicht, erfolgt durch thermische Behandlung an Luft über einen Zeitraum im Millisekundenbereich, bei der auch ein Trocknen stattfindet. In weiteren Ausführungsbeispielen kann dies auch im Vakuum oder in einer Inertgasatmosphäre erfolgen. Zur thermischen Behandlung über einen Zeitraum im Millisekundenbereich kann ein konventioneller Laser, ein Diodenlaser, ein mikrooptisch optimiertes Diodenlaserarray oder eine Blitzlampe verwendet werden. Hierdurch können auch mehrere Werkstoffe oder Werkstoffkombinationen verwendet werden.

Schließlich kann das Substrat 1 mit der Kontaktstruktur 2 und der Struktur 3 mit einer Verkapselung versehen werden, um das gesamte System unempfindlicher gegenüber harschen bzw. aggressiven Medien und Feuchtigkeit zu machen. Zum Abschluss kann der hergestellte Sensor als magnetisches Funktionselement noch durch statische oder alternierende Magnetfelder bearbeitet werden, um Offsets und Hystereseeffekte zu entfernen. Nach dieser Verkapselung zeigt der Sensor eine gute Temperaturstabilität an Luft bis zu ungefähr 125 °C.

In Figur 2a) (der linken Hälfte von Figur 2) ist in einer Draufsicht ein Ausführungsbeispiel eines entsprechend hergestellten Funktionselements in Vier-Punkt-Messgeometrie dargestellt. Wiederkehrende Merkmale sind in dieser Figur mit identischen Bezugszeichen wie in Figur 1 versehen. Figur 2b) zeigt ein Diagramm des Verlaufs des elektrischen Widerstands bei der in Figur 2a) dargestellten Konfiguration bei einer Änderung des anliegenden Magnetfelds. Dargestellt sind Messwerte für die magnetische Feldrichtung in der Probenebene (in-plane), senkrecht zur Probenebene (out-of-plane) und unter einem Winkel von 45°.

Das beschriebene gedruckte magnetische Funktionselement kann verschiedene Arten von Bewegung registrieren wie Verschiebung, Rotation oder Vibration. Dementsprechend können Lagesensoren oder Winkelsensoren hiermit realisiert werden. Alternativ oder zusätzlich können auch magnetische Schalter mit dem gedruckten magnetischen Funktionselement oder Magnetfeldsensor gebaut werden.

Lediglich in den Ausführungsbeispielen offenbarte Merkmale der verschiedenen Ausführungsformen können miteinander kombiniert und einzeln beansprucht werden, solange es unter dem Schutzumfang der beigefügten Ansprüche fällt.

## Patentansprüche

1. Verfahren zum Herstellen eines gedruckten magnetischen Funktionselements, bei dem
ein Substrat (1) auf einer Oberfläche mit mindestens einem Kontakt (2) aus einem elektrisch leitfähigen Werkstoff versehen wird,
wobei auf den oder an den mindestens einen Kontakt (2) und diesen unmittelbar berührend eine über oder neben dem Kontakt (2) angeordnete Struktur (3) aus einem den gewöhnlichen Magnetowiderstandseffekt aufweisenden Werkstoff als Paste, als Gel, als Dispersion oder als Suspension aufgedruckt wird sowie
nachfolgend der Kontakt (2) und die Struktur (3) durch eine direkte Bestrahlung mit elektromagnetischer Strahlung über einen Zeitraum im Millisekundenbereich funktionalisiert und zumindest durch ein Ausbilden einer mechanischen Anbindung zwischen einzelnen Partikeln des elektrisch leitfähigen Werkstoffs und/oder des den gewöhnlichen Magnetowiderstandseffekt aufweisenden Werkstoffs elektrisch leitfähig und magnetfeldempfindlich wird, wobei der den gewöhnlichen Magnetowiderstandseffekt aufweisende Werkstoff ausgewählt ist aus Bismut, Indium, Antimon oder einer Legierung der genannten Elemente oder Bismut, Indium, Antimon oder eine Legierung der genannten Elemente zumindest enthält,
**dadurch gekennzeichnet, dass** die angeordnete Struktur (3) mit einer definierten äußeren Kontur ohne nachfolgende formgebende Verfahrensschritte aufgedruckt wird.

2. Verfahren nach Anspruch 1, **dadurch gekennzeichnet, dass** der Zeitraum im Millisekundenbereich zwischen 0,1 ms und 100 ms, vorzugsweise zwischen 0,5 ms und 2 ms beträgt.

3. Verfahren nach Anspruch 1 oder Anspruch 2, **dadurch gekennzeichnet, dass** die Bestrahlung mit elektromagnetischer Strahlung mit einer Laserstrahlung, vorzugsweise Diodenlaserstrahlung, und/oder einer Bestrahlung mit einer Blitzlampe durchgeführt wird.

4. Verfahren nach einem der vorhergehenden Ansprüche, **dadurch gekennzeichnet, dass** der mindestens eine Kontakt (2) aus einem elektrisch leitfähigen Werkstoff durch mindestens einen Druckvorgang, eine Gasphasenabscheidung oder eine Laminierung des Kontakts aufgebracht wird.

5. Verfahren nach einem der vorhergehenden Ansprüche, **dadurch gekennzeichnet, dass** zum Drucken der Struktur (3) ein Gel, eine Paste, eine Dispersion oder eine Suspension aus dem Werkstoff, der den gewöhnlichen Magnetowiderstandseffekt aufweist, enthaltenden Pulver, einem ein Polymer aufweisendem Dispergiermittel und/oder einem Binder hergestellt wird, wobei eine mittlere Partikelgröße des Werkstoff enthaltenden Pulvers vorzugsweise zwischen 10 nm und 100 µm liegt.

6. Verfahren nach Anspruch 5, **dadurch gekennzeichnet, dass** zum Drucken der Struktur (3) eine binderfreie Suspension oder ein binderfreies Pulver verwendet wird, die auf das Substrat (1) aufgebracht werden und nachfolgend durch eine Druckbeaufschlagung und/oder Reibung in Kombination mit der Bestrahlung mit elektromagnetischer Strahlung über einen Zeitraum im Millisekundenbereich zum Erzielen eines gewöhnlichen magnetoresistiven Effekts aktiviert werden.

## Claims

1. A method for producing a printed magnetic functional element, in which
a substrate (1) is provided on a surface having at least one contact (2) made of an electrically conductive material,
wherein a structure (3) arranged above or next to the contact (2) and made of a material exhibiting the usual magnetoresistance effect is also printed as a paste, gel, dispersion or suspension on or onto the at least one contact (2) and directly touching it, and
subsequently the contact (2) and the structure (3) is functionalized by direct irradiation with electromagnetic radiation over a period of time in the millisecond range and becomes electrically conductive and sensitive to magnetic fields at least by forming a mechanical connection between individual particles of the electrically conductive material and/or the material exhibiting the usual magnetoresistance effect, wherein the material exhibiting the usual magnetoresistance effect is selected from bismuth, indium, antimony, or an alloy of the elements mentioned, or at least contains bismuth, indium, antimony, or an alloy of the elements mentioned,
**characterized in that** the arranged structure (3) is printed with a defined outer contour without subsequent shaping process steps.

2. The method according to claim 1, **characterized in that** the period of time in the millisecond range is between 0.1 ms and 100 ms, preferably between 0.5 ms and 2 ms.

3. The method according to claim 1 or claim 2, **characterized in that** the irradiation with electromagnetic radiation is carried out with a laser radiation, preferably diode laser radiation, and/or an irradiation using a flash lamp.

4. The method according to any one of the preceding claims, **characterized in that** the at least one contact (2) made of an electrically conductive material is applied by at least one printing process, a gas phase deposition or a lamination of the contact.

5. The method according to any one of the preceding claims, **characterized in that** for printing the structure (3), a gel, a paste, a dispersion or a suspension of a powder containing the material exhibiting the usual magnetoresistance effect, a dispersant containing a polymer and/or a binder is produced, wherein an average particle size of the powder containingmaterial is preferably between 10 nm and 100 µm.

6. The method according to claim 5, **characterized in that** a binder-free suspension or a binder-free powder is used for printing the structure (3), which suspension or powder is applied to the substrate (1) and is subsequently activated by the application of pressure and/or friction in combination with the irradiation with electromagnetic radiation over a period of time in the millisecond range in order to achieve a usual magnetoresistive effect.

## Revendications

1. Procédé de fabrication d'un élément fonctionnel magnétique imprimé, dans lequel
un substrat (1) est muni, sur une surface, d'au moins un contact (2) en un matériau électriquement conducteur,
dans lequel une structure (3), agencée au-dessus ou à côté du contact (2) et constituée d'un matériau présentant l'effet de magnétorésistance habituel, est imprimée sous forme de pâte, de gel, de dispersion ou de suspension sur le, ou au niveau du, au moins un contact (2) et en contact direct avec celui-ci, puis le contact (2) et la structure (3) sont fonctionnalisés grâce à une irradiation directe par rayonnement électromagnétique pendant une période de l'ordre de la milliseconde et deviennent électriquement conducteurs et sensibles aux champs magnétiques au moins par formation d'une liaison mécanique entre des particules individuelles du matériau électroconducteur et/ou du matériau présentant l'effet de magnétorésistance habituel, dans lequel le matériau présentant l'effet de magnétorésistance habituel est choisi parmi le bismuth, l'indium, l'antimoine ou un alliage des dits éléments ou au moins contient du bismuth, de l'indium, de l'antimoine ou un alliage des dits éléments,
**caractérisé en ce que** la structure (3) agencée est imprimée avec un contour extérieur défini sans étapes de procédé de mise en forme ultérieures.

2. Procédé selon la revendication 1, **caractérisé en ce que** la période de temps de l'ordre de la milliseconde est comprise entre 0,1 ms et 100 ms, de manière préférée entre 0,5 ms et 2 ms.

3. Procédé selon la revendication 1 ou la revendication 2, **caractérisé en ce que** l'irradiation par rayonnement électromagnétique est mise en œuvre avec un rayonnement laser, de manière préférée un rayonnement de diode laser, et/ou une irradiation avec une lampe flash.

4. Procédé selon l'une quelconque des revendications précédentes, **caractérisé en ce que** le au moins un contact (2) constitué d'un matériau électriquement conducteur est appliqué grâce à au moins une opération d'impression, un dépôt en phase gazeuse ou une stratification du contact.

5. Procédé selon l'une quelconque des revendications précédentes, **caractérisé en ce qu'**un gel, une pâte, une dispersion ou une suspension d'une poudre contenant le matériau présentant l'effet de magnétorésistance habituel, d'un agent dispersant contenant un polymère et/ou d'un liant est préparé(e) afin d'imprimer la structure (3), dans lequel une taille moyenne de particules de la poudre contenant le matériau est de manière préférée comprise entre 10 nm et 100 µm.

6. Procédé selon la revendication 5, **caractérisé en ce qu'**une suspension sans liant ou une poudre sans liant, qui est appliquée sur le substrat (1) et qui est ensuite activée grâce à une application de pression et/ou un frottement en combinaison avec l'irradiation par rayonnement électromagnétique pendant une période de l'ordre de la milliseconde afin d'obtenir un effet magnétorésistif habituel, est utilisée pour imprimer la structure (3).
